# EUROPEAN PATENT APPLICATION

(11) **EP 4 825 699 A1**
(43) Date of publication of application: **21.10.2026**
(21) Application number: 25305567.7
(22) Date of filing: 17.04.2025
(51) Int. Cl.: B61C 17/04, H05K 7/20, B60H 1/00

(54) **THERMAL REGULATION SYSTEM FOR A RAILWAY VEHICLE**

(71) Applicant: SpeedInnov, 75008 Paris (FR)
(72) Inventor: AUDEMAR, Christophe, 65310 HORGUES (FR); BOUNHOURE, Mathieu, 65000 TARBES (FR)
(74) Representative: Plasseraud IP

(57) **Abstract**

A thermal regulation system (10) for a multi-component system (3) of a railway vehicle (1), the thermal regulation system (10) comprising: a fan (12) configured to extract air out of the railway vehicle (1); a conduit network (20) comprising a plurality of inlet openings and at least one outlet opening (28) fluidly connected to the fan (12); and a plurality of flow rate controllers each arranged at a respective inlet opening of the plurality of inlet openings, the flow rate controllers being configured to control, independently from one another, a flow rate of air passing through the respective inlet opening.

## Description

### Technical field

The present disclosure relates to a system for regulating heat in a railway vehicle and in particular in locomotives. In a non-limiting example, the railway vehicle is a high-speed multi-deck train.

### Background art

Document EP 0 943 520 A1 discloses a cooling system for a cabinet containing electric components. A fan is provided and is actuated to force an air flow through a heat exchanger.

This arrangement is not adapted for the upcoming challenges related to the increase in power/torque produced by locomotives today, to their intensive use, or to the external hotter temperatures.

### Summary of the invention

The present disclosure proposes an answer to this issue by providing a thermal regulation system for a multi-component system of a railway vehicle, the thermal regulation system comprising: a fan configured to extract air out of the railway vehicle; a conduit network comprising a plurality of inlet openings and at least one outlet opening fluidly connected to the fan; and a plurality of flow rate controllers each arranged at a respective inlet opening of the plurality of inlet openings, the flow rate controllers being configured to control, independently from one another, a flow rate of air passing through the respective inlet opening.

This arrangement provides a more efficient control of the temperature (cooling) of components thanks to increased air renewal rate.

The improved control of temperatures makes it possible to produce a higher power output (for advancing/accelerating or braking) without any risk of damaging the components or the locomotive. In addition, the fact that the flow rate controllers are independently set allows them to *spatially* adjust the zones which may remain hot and the zones which need to be cooled down. The adjustment may also be controlled to adjust the amount of heat extracted from a given component *with time.* Comparative measurements have shown that in some situations, the conduit network and the flow rate controllers may reduce the temperature by at least 4°C and up to 8°C. Moreover, the proposed system may easily be retrofitted into existing equipment which may only contain a fan already used for cooling other components. The retrofit process can advantageously be performed with passive elements (conduit network and flow rate controller) and without the need to add an active actuator (e.g., another fan).

In the present document, a component is intended to refer to any apparatus or assembly that produces heat. Non-limiting examples of components are electric components such as power inverter or single-phase forced-switching bridge (or PMCF in French for "Pont Monophasé à Commutation Forcée").

The wording "configured to extract air out of the railway vehicle" when referring to the fan is intended to mean that the fan generates in the vehicle a vacuum or an air flow that is (in the railway vehicle) directed in the direction of the fan, and that the fan is, directly or indirectly, fluidly connected to the outer environment of the vehicle. In other words, the fan of the present disclosure does not blow air on the components.

In some examples, the conduit network comprises at least one pipe and the plurality of inlet openings is arranged on the at least one pipe. In some examples, the at least one pipe is a linear pipe. It is convenient to arrange the inlet openings on linear pipe because a wider range of designs of flow rate controller may be adapted on a linear pipe than on a non-linear pipe. Also, the automatization of the flow rate controller by linear actuator is easier on linear pipe. The inlet openings may be exclusively arranged on the linear pipe(s).

In some examples, the at least one pipe comprises a first pipe and a second pipe, the first pipe being arranged parallel to and vertically and/or horizontally offset from the second pipe. This arrangement ensures that, when there are two rows of overlapping components, heat is directly collected at closest locations to the components.

In some examples, the at least one pipe has a rectangular cross section. Such a cross section maximizes the ratio of maximum air flow over bulkiness of the conduit network. Most electric components are of parallelepipedal shape and a rectangular cross section maximizes the size of the inlet openings close to the components.

In some examples, each flow rate controller comprises a fixed grating, immobile with respect to the conduit network and comprising apertures, the flow rate controller further comprising a movable grating, configured to be moved with respect to the fixed grating so as to cover a selective portion of each of the apertures. The movement of the movable grating may consist in a sliding or pivoting motion. In some examples, some of the apertures may be obturated while others remain uncovered. In some other examples, all the apertures of an inlet opening are, for a given setting of the movable grating, open to a same extent.

In a variant example, at least one of the flow rate controllers comprises an adjustable actuator. The adjustable actuator may be an adjustable valve.

In some examples, the fan is configured to generate a vacuum in the conduit network of at least -200 Pa. The fan may generate a vacuum comprised between -200 Pa and -400 Pa, preferably between -250 Pa and -350 Pa.

In some examples, the fan is configured to generate an air flow rate of at least 100 liters per second. In some examples, the maximum flow of air of an inlet opening is comprised between 5 and 20 liters per second.

The invention also relates to a multi-component system of a railway vehicle comprising: at least one group of components; and a thermal regulation system according to any of the above examples, wherein each of the inlet openings is arranged above a respective component of the at least one group of components. A group of components may be arranged as a row of components.

In the present disclosure, "above" is intended to refer to the relative position of one element with respect to another element, when the system is used in a regular and intended orientation. "A first element being above a second element" is intended to mean that, in a three-axis coordinate system (x,y,z) at least one geometric point of the first element shares x and y coordinates with at least one geometric point of the second element, while the two points have a different z coordinate. A partial overlap is intended to fall under the wording "above".

In some examples, the conduit network comprises at least two pipes and the at least one group of components comprises at least two groups of components, wherein each of the at least two pipes is respectively arranged above one of the at least two groups of components. This arrangement ensures that the inlet openings are directly above the components emitting heat.

In some examples, the at least one group of components comprises at least one lower group and one upper group, the upper group being arranged above the lower group and one of the at least two pipes being placed between the lower group and the upper group. This arrangement is particularly compact and efficient for extracting heat.

In some examples, the at least one group of components comprises a power inverter and a single-phase forced-switching bridge.

The invention also relates to a railway vehicle comprising a multi-component system as discussed above and an air inlet provided with an air filter. The railway vehicle can be a locomotive, a passenger carriage or a freight carriage. The air inlet allows a balance of the pressure in the vehicle as the fan extracts air out of the vehicle. The air filter ensures that air entering the vehicle is pure and dry, thereby protecting the components as well as the conduit network and the fan.

The invention also relates to a method for setting up a railway vehicle, the railway vehicle comprising a fan configured to extract air out of the railway vehicle, the method comprising: providing a conduit network, the conduit network comprising a plurality of inlet openings; connecting the conduit network to the fan; providing a plurality of flow rate controllers; arranging each of the flow rate controllers at a respective inlet opening of the plurality of inlet openings; and setting each flow rate controller at a respective setting independently from the other flow rate controllers, so as to control a flow rate of air passing through the respective inlet opening.

The vehicle may comprise components and the inlet openings may be arranged each above a respective component.

In some examples, the fan comprises a main air inlet, and connecting the conduit network to the fan comprises providing the fan with a secondary air inlet and connecting the conduit network to the secondary air inlet of the fan. The secondary inlet may be formed in the fan casing with the aim of retrofitting an existing fan so as to receive air from the conduit network in addition to the air of the vehicle.

### Brief description of the figures

Fig. 1 shows a vehicle with a thermal regulation system.
Fig. 2 depicts a magnified portion of the thermal regulation system.
Fig. 3 illustrates a method for setting up a vehicle.

### Detailed description of an embodiment

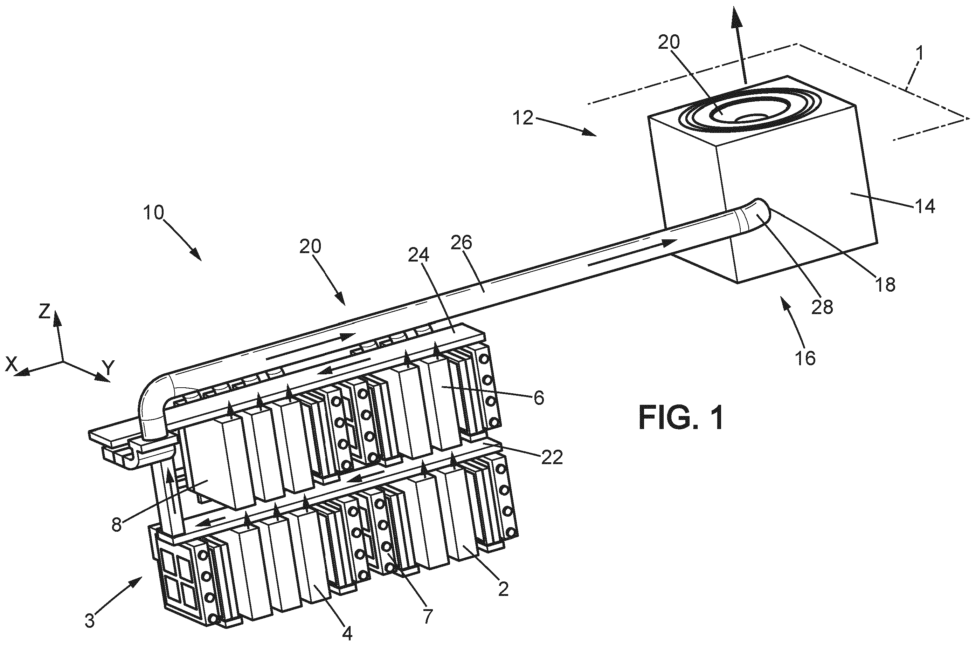

Figure 1 shows an example of a vehicle 1. In the context of the present disclosure, the vehicle 1 is a railway vehicle of any size, shape, form or intended purpose. Although the disclosure focuses on railway vehicles, the reader will understand that the same concepts can be applied to other technical field, such as land vehicles, buildings, marine vessels, industrial plants, etc.

A coordinate system is illustrated where axis X is aligned with the longitudinal direction of the vehicle 1, while axis Y is a transversal axis and axis Z represents the vertical direction.

The vehicle 1 may be equipped with a series of components 2, 4, 6, 8. The components constitute together a multi-component system 3. In this example, the components 2, 4, 6, 8 are arranged in two groups, an upper group and a lower group. In each group, the components may arranged as a row for example aligned along the longitudinal direction X. Components 2, 4, 6, 8 are capacitors and are placed in a cabinet (not shown) in this example; component 7 is a power module in this example and both are cooled more efficiently thanks to increased air renewal around them in the cabinet. The components 2, 4, 6, 8 may rest on grid-like supports to facilitate air flowing into and/or around the components 2, 4, 6, 8.

The vehicle 1 further comprises a thermal regulation system 10. The thermal regulation system comprises a fan 12.

The fan 12 is configured to create a depression and/or suck air. In this example, air is extracted in a vertical direction above the vehicle (see arrow). To that end, the fan is in fluid communication with an opening on the roof of the vehicle 1. The vehicle may comprise an air inlet provided with an air filter, to balance the pressure inside the vehicle, as the fan 12 propels air outside of the vehicle. In another example of embodiment, air is sucked from an opening in the roof of the vehicle, and down though the bottom of the vehicle.

The fan 12 comprises a fan casing 14 which may be of a substantially parallelepipedal shape. The fan casing 14 may comprise a main air inlet 16 which is intended to extract hot air out of the vehicle 1.

The fan 12 may generate a vacuum comprised between -200 Pa and -400 Pa, preferably between -250 Pa and -350 Pa, and of at least -200 Pa. The fan 12 may generate an air flow rate of at least 100 liters per second.

The thermal regulation system 10 comprises a conduit network 20 which may be connected to a secondary air inlet 18 of the fan casing 14. The secondary inlet 18 may be configured to let through an air flow that is substantially smaller (e.g., at least 3 or at least 5 times smaller) than the air flow that can pass through the main air inlet 16 of the fan 12. In some examples, the thermal regulation system 10 is connected to the fan 12 at more than one secondary air inlet 18.

The conduit network 20 may comprise one or more pipes 22, 24. The illustrated example shows two linear pipes 22, 24 arranged one above the other. The illustrated example shows that the pipes 22, 24 can have a rectangular cross-section. The pipes 22, 24 may have a similar cross-section. In some cases, the pipe 24, which lies at a higher altitude than the pipe 22, has a bigger cross-section, for instance at least 10% bigger, so that more air at higher altitude may be sucked in.

The pipes 22, 24 merge into a manifold 26 which has an outlet opening 28 fluidly connected to fan 12, for example through the secondary air inlet 18.

In alternative embodiments, the pipes are replaced with pipes of appropriate shape, e.g., curved or wavy.

The conduit network 20 comprises inlet openings which allow air to enter the conduit network. The inlet openings are arranged above respective components 2, 4, 6, 8.

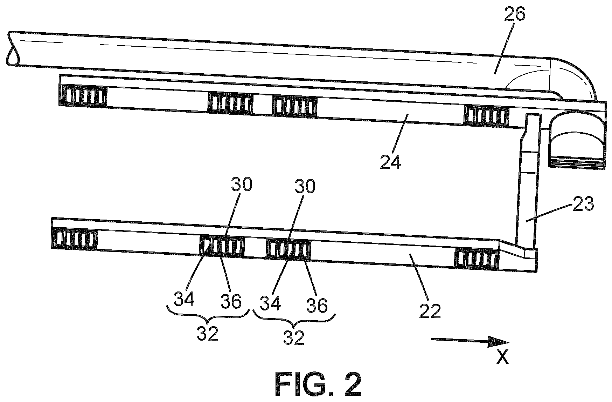

Figures 2 shows a portion of the conduit network 20 in greater detail. The inlet openings are indicated with label 30. The inlet openings 30 may be square or rectangular through-holes in the pipes.

Each of the inlet openings 30 is equipped with a flow rate controller 32. The flow rate controller 32 may be of any kind adapted to restrict at least partially access of air through the inlet openings.

In some examples, the flow rate controller 32 is constituted by a fixed grating 34 and a movable grating 36. The fixed grating 34 comprises a plurality of apertures and is fixed to the conduit network 20. The movable grating 36 comprises a plurality of apertures and in that respect, the movable grating 36 may mirror the design of the fixed grating 34, such that in one position of the movable grating 36, the apertures of the slidable grating 36 align with the apertures of the fixed grating 34. In that position, a maximum amount of air can pass through the inlet opening 30. In other positions of the movable grating 36, the apertures of the gratings do not align and thus the apertures of the fixed grating 34 are at least partially obturated by the movable grating 36. The flow rate and/or speed of air passing through the inlet opening is thus reduced. The movable grating 36 may be a slidable grating.

The maximum flow rate passing through the inlet openings may be comprised between 0 and 20 liters per second.

The movement of the movable grating 36 can be performed manually by an operator acting on an actuator, e.g., a button or a rod. Alternatively, the movement can be performed automatically by a linear actuator, e.g., a piston or by a rotating actuator. The movement may be a sliding movement.

In a variant design, the flow rate controller is formed by an adjustable actuator, i.e. a valve, which can be manually or automatically commanded to restrict passage of air through the respective inlet opening 30.

Each flow rate controller 32 can be adjusted independently from the other flow rate controllers, so that some inlet openings accept a higher flow rate to cool down some portions of the vehicle more than others.

In the illustrated example, the inlet openings 30 (and the flow rate controllers 32) are arranged on the pipes 22, 24 but other arrangements may be envisaged.

The pipes 22, 24 may be fluidly connected through a vertical pipe 23. In a variant, each pipe 22, 24 has a longitudinal end in communication with the manifold 26. The vertical pipe 23 may have a rectangular cross-section. It may be bent to accommodate to the structure or other elements present in the vehicle at that location.

**In** the illustrated example, the pipes 22, 24 are aligned along the longitudinal direction X of the vehicle but other arrangements are possible. The pipes 22, 24 are drawn as extending horizontally (in the X, Y plane) but other orientations can be foreseen. The pipes 22, 24 may not be parallel to one another, for example, they can form an angle of at least 10°.

The manifold 26 may comprise a portion that is parallel to (at least one of) the pipes 22, 24.

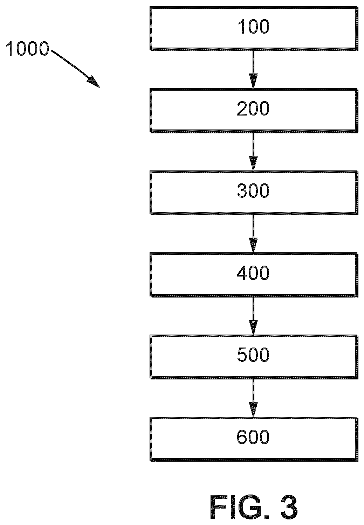

Figure 3 illustrates a method 1000 for setting up a vehicle as described above, the vehicle having a fan. The method 1000 comprises a step of providing 100 a conduit network as discussed above, with a plurality of openings. The conduit network is then connected 200 to the fan.

The method continues with a step of providing 300 the flow rate controllers as exemplified above and arranging 400 the flow rate controllers at respective inlet openings of the conduit network. The steps 300 and 400 may be performed before the conduit network has been /will be connected 200 to the fan.

Then, the flow rate controllers are set 500 at a respective setting, independently from one another, to appropriately cool down the vehicle. The setting of the controllers may be performed before or after the conduit network is connected 200 to the fan, and before or after flow rate controllers are arranged at respective inlet openings. The higher the heat produced by a component, the higher the flow rate of the inlet opening above that component.

The step connecting 200 the conduit network to the fan may comprise providing the fan with the secondary inlet (18 on Fig.1) and connecting the conduit network to the secondary inlet 18.

## Claims

1. A thermal regulation system (10) for a multi-component system (3) of a railway vehicle (1), the thermal regulation system (10) comprising:
a fan (12) configured to extract air out of the railway vehicle (1);
a conduit network (20) comprising a plurality of inlet openings (30) and at least one outlet opening (28) fluidly connected to the fan (12); and
a plurality of flow rate controllers (32) each arranged at a respective inlet opening (30) of the plurality of inlet openings (30), the flow rate controllers (32) being configured to control, independently from one another, a flow rate of air passing through the respective inlet opening (30).

2. The thermal regulation system (10) of claim 1, wherein the conduit network (20) comprises at least one pipe (22, 24) and the plurality of inlet openings (30) is arranged on the at least one pipe (22, 24).

3. The thermal regulation system (10) of claim 2, wherein the at least one pipe (22, 24) is a linear pipe (22, 24).

4. The thermal regulation system (10) of claim 2 or 3, wherein the at least one pipe (22, 24) comprises a first pipe (22) and a second pipe (24), the first pipe (22) being arranged parallel to and vertically and/or horizontally offset from the second pipe (24).

5. The thermal regulation system (10) of any of claims 2-4, wherein the at least one pipe (22, 24) has a rectangular cross section.

6. The thermal regulation system (10) of any of the preceding claims, wherein each flow rate controller (32) comprises a fixed grating (34), immobile with respect to the conduit network (20) and comprising apertures, the flow rate controller (32) further comprising a moving grating (36), configured to be moved with respect to the fixed grating (34) so as to cover a selective portion of each of the apertures.

7. The thermal regulation system (10) of any of the claims 1 to 5, wherein at least one of the flow rate controllers (32) comprises an adjustable actuator.

8. The thermal regulation system (10) of any of the preceding claims, wherein the fan (12) is configured to generate a vacuum in the conduit network of at least -200 Pa.

9. The thermal regulation system (10) of any of the preceding claims, wherein the fan (12) is configured to generate an air flow rate of at least 100 liters per second.

10. A multi-component system (3) of a railway vehicle (1) comprising:
at least one group of components (2, 4, 6, 8); and
a thermal regulation system (10) according to any of the preceding claims, wherein each of the inlet openings (30) is arranged above a respective component (2, 4, 6, 8) of the at least one group of components.

11. The multi-component system (3) of claim 10, wherein the conduit network (20) comprises at least two pipes (22, 24) and wherein the at least one group of components comprises at least two groups of components, wherein each of the at least two pipes (22, 24) is respectively arranged above one of the at least two groups of components.

12. The multi-component system (3) of claim 10 or 11, wherein the at least one group of components comprises at least one lower group (2, 4) and one upper group (6, 8), the upper group (6, 8) being arranged above the lower group (2, 4) and one of the at least two pipes (22) being placed between the lower group (2, 4) and the upper group (6, 8).

13. The multi-component system (3) of any of claims 10 to 12, wherein the at least one group of components (2, 4, 6, 8) comprises a power inverter and a single-phase forced-switching bridge.

14. A railway vehicle (1) comprising a multi-component system (2, 4, 6, 8) according to any of claims 10 to 13 and an air inlet provided with an air filter.

15. A method (1000) for setting up a railway vehicle (1), the railway vehicle (1) comprising a fan (12) configured to extract air out of the railway vehicle (1), the method comprising:
providing (100) a conduit network (20), the conduit network (20) comprising a plurality of inlet openings (30);
connecting (200) the conduit network (20) to the fan (12);
providing (300) a plurality of flow rate controllers (32);
arranging (400) each of the flow rate controllers (32) at a respective inlet opening (30) of the plurality of inlet openings; and
setting (500) each flow rate controller (32) at a respective setting independently from the other flow rate controllers (32), so as to control a flow rate of air passing through the respective inlet opening (30).

16. The method (1000) of claim 15, wherein the fan (12) comprises a main air inlet (16), and connecting (200) the conduit network (20) to the fan (12) comprises providing the fan (12) with a secondary air inlet (18) and connecting the conduit network (20) to the secondary air inlet (18) of the fan (12).
